Europäisches Patentamt

European Patent Office

Office européen des brevets

(19)

(11) Veröffentlichungsnummer: **0 666 650 A2**

## (12) EUROPÄISCHE PATENTANMELDUNG

(21) Anmeldenummer: **95100452.2**

(51) Int. Cl.6: **H03M 7/00**

(22) Anmeldetag: **13.01.95**

(30) Priorität: **24.01.94 DE 4401883**

(43) Veröffentlichungstag der Anmeldung:
**09.08.95 Patentblatt 95/32**

(84) Benannte Vertragsstaaten:
**CH DE FR GB LI NL SE**

(71) Anmelder: **SIEMENS AKTIENGESELLSCHAFT**
**Wittelsbacherplatz 2**
**D-80333 München (DE)**

(72) Erfinder: **Hein, Sören, Dr.**
**Widenmayerstrasse 17/3**
**D-80538 München (DE)**

(54) Verfahren zur schnellen Decodierung der Ausgangssignale von Sigma Delta Modulatoren.

(57) Bei diesem Verfahren wird das decodierte Ausgangssignal eines Modulators mit Hilfe einer Folge von Iterationsschritten gewonnen. Dabei werden in jedem Schritt zwei Operationen $P_1$ bzw. $P_2$ nacheinander ausgeführt, wobei die Signale s durch Komponenten $s(n)$, $s(n-1)$, $s(n-2)$, ..., $s(n-k)$ dargestellt werden, die zeitliche Abtastwerte dieser Signale sind. Die Operation $P_1$ ist eine Projektion im Raum aller Eingangssignale des Modulators auf die Menge aller derjenigen Eingangssignale, welche der Modulator auf das zu decodierende Ausgangssignal abbildet. Die Operation $P_2$ ist eine Projektion auf den Unterraum aller bandbegrenzten Eingangssignale des Modulators. Für beide Operationen wird eine Darstellung der Signale gewählt, in welcher die Operation $P_1$ komponentenweise ausgeführt werden kann. Das Verfahren ist erheblich ($10^4$ bis $10^5$ mal) schneller als alle bekannten Verfahren zur Decodierung der Ausgangssignale von Sigma Delta Modulatoren mit vergleichbarer Genauigkeit und nur zwei bis zehn mal langsamer als wesentlich ungenauere lineare Decodierungsverfahren. Es kann im Zusammenhang mit allen geläufigen Sigma Delta Architekturen angewendet werden.

EP 0 666 650 A2

Die Erfindung betrifft ein Verfahren zur schnellen Decodierung der Ausgangssignale von Sigma Delta Modulatoren, d.h. zur schnellen Erzeugung eines hochauflösenden digitalen Codes mit normaler Abtastfrequenz aus einem zeitlich stark überabgetasteten Code mit viel geringerer Auflösung, wobei beide Codes ein zeitlich abgetastetes analoges Signal, das Eingangssignal eines zur Analog-Digital-Wandlung eingesetzten Sigma Delta Modulators, in digitaler Form approximieren.

Sigma Delta Modulatoren [1] sind einfache, stark nichtlineare Schaltungen, die zur Analog-Digital-Wandlung, z.B. für Sprach- oder Tonsignale in der Audiotechnik, aber ebenso in vielen anderen Bereichen der Informations- und Kommunikationstechnik, wie z.B. in der Nachrichtentechnik, benutzt werden können. Sie lassen sich sehr kostengünstig mit den für Digitalschaltungen üblichen, einfachen Prozessen herstellen und zusammen mit Digitalschaltungen auf einem Chip integrieren. Hochpräzise und damit teure Komponenten werden für ihren Aufbau nicht benötigt; die erforderliche hohe Auflösung wird stattdessen durch eine erhöhte Taktrate in Verbindung mit einer geschlossenen, sich selbst korrigierenden, rückgekoppelten Signalschleife gemäß dem Prinzip der Differenz-Puls-Code-Modulation (DPCM), erreicht.

Ein analoges, zeitlich weit oberhalb der Nyquist-Frequenz abgetastetes Eingangssignal wird von einem Sigma Delta Modulator in ein sehr grob quantisiertes, ebenfalls extrem überabgetastetes Ausgangssignal überführt. Die Quantisierung ist normalerweise einstufig, so daß das Ausgangssignal des Modulators im typischen Fall binär ist. Dieses binäre, extrem überabgetastete Signal muß nun in ein hochauflösendes Signal, d.h. ein digitales Signal mit einer größeren Wortbreite von z.B. 16 Bit, welches dafür allerdings eine erheblich geringere Abtastfrequenz besitzen darf, überführt werden. Dieser Vorgang wird auch als Decodierung bezeichnet.

Die konventionellen, auf linearer Filterung [2] basierenden Methoden zur Decodierung der Ausgangssignale von Sigma Delta Modulatoren sind nicht in der Lage, die gesamte relevante Information aus dem Ausgangssignal zu extrahieren. Diese Methoden benutzen lediglich die Begrenzung des Spektrums des analogen Eingangssignals auf ein bestimmtes Band, machen aber von der speziellen Art der bitweise sequentiellen Erzeugung des binären Datenstroms durch den Modulator, also von der durch die Architektur des Modulators gegebenen Beziehung zwischen dem Eingangssignal und dem Ausgangssignal, keinen Gebrauch. Aus diesem Grunde sind die Ergebnisse dieser konventionellen, auf linearer Filterung basierenden Methoden mit häufig nicht tolerierbaren Fehlern, in Form eines zu schlechten Signal-Rausch-Verhältnisses, verbunden.

Hein und Zakhor beschreiben in [3] ein nichtlineares Verfahren zur Decodierung von Sigma Delta Modulatoren, mit welchem ein erheblich besseres Signal-Rausch-Verhältnis erzielt werden kann. Dieses Verfahren basiert auf einer alternierenden Iteration

$$x_{n+1} = P_2(P_1(x_n))$$

mit Hilfe zweier Projektionen $P_1$ und $P_2$ auf zwei konvexe Teilmengen von Signalräumen, wobei die eine Teilmenge diejenigen analogen Eingangssignale des Modulators umfaßt, welche den zu decodierenden binären Datenstrom als Ausgangssignal erzeugen, und wobei die andere Teilmenge gleich dem Raum aller bandbegrenzten Signale ist, der z.B. von einem Satz von bandbegrenzten Basissignalen aufgespannt wird. Die alternierende Iteration konvergiert gegen einen Fixpunkt, welcher der Schnittmenge beider konvexer Teilmengen angehört. Dieses Fixpunktsignal ist folglich die gesuchte digitale Entsprechung desjenigen bandbegrenzten analogen Eingangssignals des Modulators, welches den zu decodierenden binären Datenstrom als Ausgangssignal erzeugt.

Das in [3] beschriebene, nichtlineare Verfahren ist somit dem konventionellen, linearen Ansatz grundsätzlich überlegen, weil es nicht nur die spektralen Eigenschaften des Eingangssignals zur Decodierung verwendet, sondern zusätzlich von der durch die Architektur des Modulators gegebenen Beziehung zwischen dem Eingangssignal und dem Ausgangssignal Gebrauch macht. Leider ist dieses Verfahren mit einem unverhältnismäßig hohen Rechenaufwand verbunden - und deshalb zu teuer und zu langsam -, wodurch seine praktische Verwendbarkeit zur Decodierung von Sigma Delta Modulatoren, die ja gerade durch besonders einfache und daher kostengünstige Schaltungen realisierbar sind, stark eingeschränkt wird.

Der Erfindung liegt daher die Aufgabe zugrunde, ein Verfahren zur schnellen Decodierung der Ausgangssignale von Sigma Delta Modulatoren anzugeben, welches zu seiner Durchführung eines wesentlich verringerten Rechenaufwandes bedarf als - und dabei gleichzeitig so genau ist wie - das in [3] beschriebene nichtlineare Verfahren.

Diese Aufgabe wird erfindungsgemäß durch ein Verfahren zur schnellen Decodierung der Ausgangssignale von Sigma Delta Modulatoren mit Merkmalen nach Anspruch 1 gelöst.

2

Bei diesem Verfahren wird das decodierte Ausgangssignal eines Modulators mit Hilfe einer Folge $x_{n+1} = P_2(P_1(x_n))$ von Iterationsschritten gewonnen, wobei $x_0$ ein vorgegebenes Startsignal ist, d.h. in jedem Schritt werden zwei Operationen $P_1$ bzw. $P_2$ nacheinander ausgeführt, wobei die Signale s durch Komponenten s(n), s(n-1), s(n-2), ..., s(n-k) dargestellt werden, die zeitliche Abtastwerte dieser Signale sind. Dabei ist die Operation $P_1$ eine Projektion im Raum aller Eingangssignale des Modulators auf die Menge aller derjenigen Eingangssignale, welche der Modulator auf das zu decodierende Ausgangssignal abbildet, die Operation $P_2$ eine Projektion auf den Unterraum aller Eingangssignale des Modulators, deren Frequenzspektrum in einer vorgegebenen Weise begrenzt ist, wobei für beide Operationen eine Darstellung der Signale gewählt wird, in welcher die Operation $P_1$ komponentenweise ausgeführt werden kann, so daß jede Komponente $P_1(s)(k)$ von $P_1(s)$ getrennt von allen übrigen Komponenten $P_1(s)(k')$ mit $k' \neq k$ ermittelt wird.

Durch diese komponentenweise Durchführung der Operation $P_1$ wird der Rechenaufwand zur Durchführung des erfindungsgemäßen Verfahrens gegenüber dem bekannten Verfahren so entscheidend reduziert, daß das erfindungsgemäße Verfahren ohne weiteres für die kommerzielle Verwendung zur Decodierung der Ausgangssignale von Sigma Delta Modulatoren geeignet ist. Das Verfahren ist erheblich ($10^4$ bis $10^5$ mal) schneller als alle bekannten Verfahren zur Decodierung der Ausgangssignale von Sigma Delta Modulatoren mit vergleichbarer Genauigkeit und nur zwei bis zehn mal langsamer als wesentlich ungenauere lineare Decodierungsverfahren. Es kann im Zusammenhang mit allen geläufigen Sigma Delta Architekturen angewendet werden.

Vorteilhafte Weiterbildungen der Erfindung ergeben sich aus den Unteransprüchen.

Bei einer bevorzugten Ausführungsform des erfindungsgemäßen Verfahrens wird die Operation $P_1$ gemäß der Vorschrift

$$P_1(x_n)(k) = \begin{cases} x_n(k) \quad \text{falls} \quad y(k) \cdot x_n(k) \leq y(k) \cdot (Hy)(k) \\ \qquad (Hy)(k) \quad \text{sonst} \end{cases}$$

durchgeführt wird, wobei y der Vektor $y = (y(0),...,y(N-1))$ des zu decodierenden Ausgangssignals des Modulators und

$$H = \begin{pmatrix} h_1 & 0 & \cdots & 0 & 0 \\ h_2 & h_1 & \cdots & 0 & 0 \\ \vdots & \vdots & & \vdots & \vdots \\ h_{N-1} & h_{N-2} & \cdots & h_1 & 0 \\ h_N & h_{N-1} & \cdots & h_2 & h_1 \end{pmatrix}$$

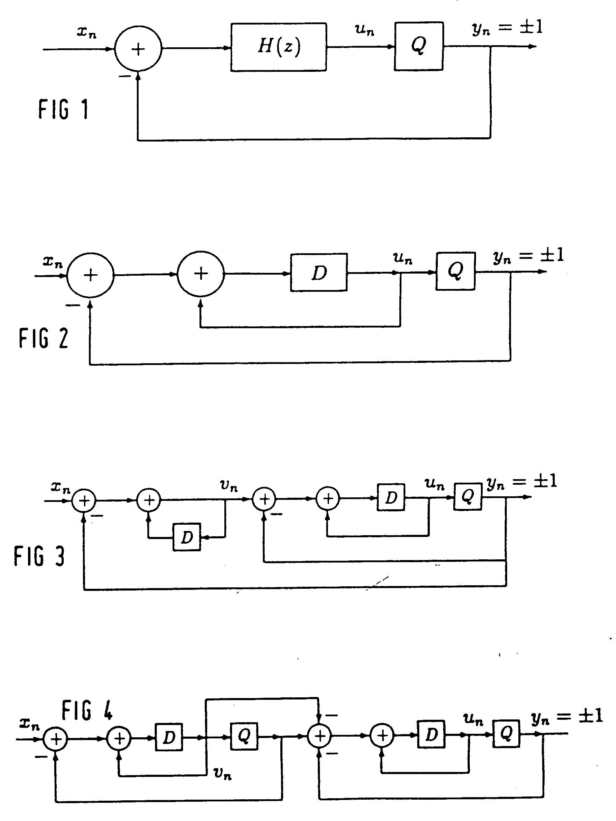

die Matrix der Impulsantwortkoeffizienten des in die nichtlineare Rückkopplungsschleife des Modulators eingebetteten linearen Filters (z.B. Figur 1) ist. Bei dieser Ausführungsform wird das zu decodierende Ausgangssignal y mit Hilfe der Matrix H in eine Darstellung transformiert, in welcher die Operation $P_1$ komponentenweise durchgeführt werden kann. Da hierbei der Signalvektor x ebenfalls in einer Darstellung vorliegt, welche auf das Bild des zu decodierenden Ausgangssignals unter der Matrix H führt, also im Bildbereich von H liegt, muß die orthogonale Projektionen $P_2$ ebenfalls so durchgeführt werden, daß sie ein Signal s auf das Bild des Unterraumes der bandbegrenzten Signale unter der Matrix H projiziert.

Ein weiteres bevorzugtes Ausführungsbeispiel des erfindungsgemäßen Verfahrens sieht deshalb vor, daß die Operation $P_2$ zu dem Ausdruck

$$P_2(s) = \sum_i Hb_i \cdot (b|H^T Hb)_{i,j}^{-1} \cdot (Hb_j|s)$$

äquivalent sein soll, wobei die Vektoren $b_i = (b_i(0),...,b_i(N-1))$ Basissignale eines Unterraumes von bandbegrenzten Signalen im Raum aller Eingangssignale des Modulators, H die Matrix der Impulsantwortkoeffizienten des in die nichtlineare Rückkopplungsschleife des Modulators eingebetteten linearen Filters (z.B. Figur 1), ( | ) das euklidische Skalarprodukt auf dem Raum der Signalvektoren und

$$(b|H^{T}Hb)_{i,j}^{-1}$$

die Koeffizienten der inversen Matrix der Skalarprodukte $(b_q|H^{T}Hb_r)$ bezeichnen.

Die Konvergenz der oben beschriebenen Iteration läßt sich ferner wesentlich dadurch beschleunigen, daß gemäß einer bevorzugten Ausführungsform der Erfindung eine modifizierte Iteration der Form $X_{n+1}$ = $P_2(P_1(\alpha \cdot x_n + (1-\alpha) \cdot x_{n-1}))$ verwendet wird, wobei der Parameter $\alpha$ bei der Ausführung der Operation $P_1$ optimal gewählt wird. Eine weitere Beschleunigung des Verfahrens, die allerdings mit einem möglichen Genauigkeitsverlust verbunden ist, läßt sich schließlich dadurch erreichen, daß ein zeitlich unterabgetastetes Ausgangssignal des Modulators decodiert wird. Diese Unterabtastung des Ausgangssignals kann besonders vorteilhaft durch den Quantisierungsfehler des Modulators gesteuert werden.

Figur 1 zeigt ein zeitlich diskretes Modell eines interpolatives Sigma Delta Modulators.

Figur 2 zeigt ein zeitlich diskretes Modell eines Sigma Delta Modulators mit einer Rückkopplungsschleife.

Figur 3 zeigt ein zeitlich diskretes Modell eines Sigma Delta Modulators mit doppelter Rückkopplungsschleife.

Figur 4 zeigt ein zeitlich diskretes Modell eines zweistufigen Sigma Delta Modulators.

Figur 5a zeigt ein Filter vierter Ordnung.

Figur 5b zeigt das inverse Filter zu dem in Figur 5a dargestellten Filter.

Im folgenden wird die Erfindung anhand bevorzugter Ausführungsbeispiele und mit Hilfe der Figuren näher beschrieben.

Ein allgemeiner, interpolativer Sigma Delta Modulator ist schematisch in Figur 1 dargestellt. Er besteht aus einem zeitlich diskreten, linearen analogen Filter H(z), der in eine nichtlineare Schleife mit negativer Rückkopplung eingebettet ist. Das nichtlineare Element in der Schleife ist ein Quantisierer, dessen Auflösung typisch 1 Bit beträgt. Das erfindungsgemäße Verfahren ist jedoch nicht auf Modulatoren mit einstufiger Quantisierung beschränkt, und der Fachmann ist mit Hilfe der ihm zur Verfügung stehenden allgemeinen Kenntnisse ohne weiteres in der Lage, das im Rahmen dieser Patentanmeldung für den Fall der einstufigen Quantisierung dargestellte Verfahren so abzuwandeln, daß es für den mehrstufigen Fall angewendet werden kann.

Der einstufige Quantisierer wird durch die Beziehung

$$Q(u) = \begin{cases} +1 \text{ falls } u > 0 \\ -1 \text{ falls } u \leq 0 \end{cases}$$

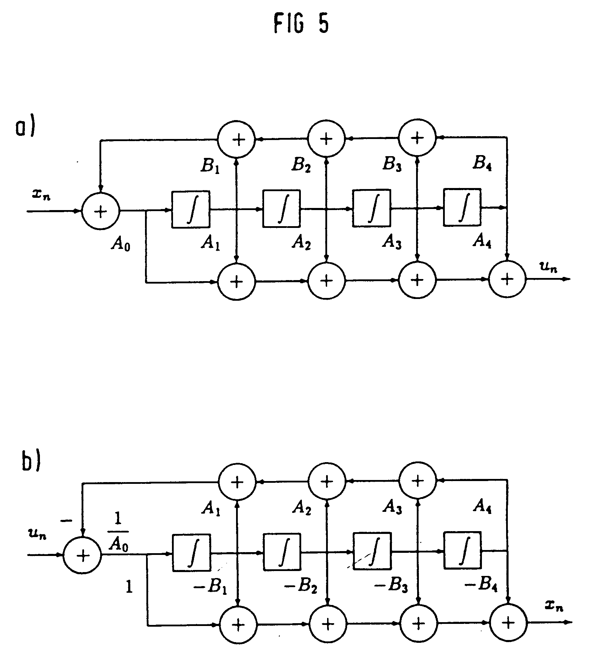

beschrieben. Aus Gründen der Übersichtlichkeit wird das erfindungsgemäße Verfahren in dieser Patentanmeldung nur für den sogenannten interpolativen Modulator beschrieben, weil der Fachmann mit Hilfe der ihm zur Verfügung stehenden allgemeinen Kenntnisse ohne weiteres in der Lage ist, das Verfahren für beliebige andere Modulatorarchitekturen abzuwandeln. Der Ein-Schleifen-Modulator gemäß Figur 2 ist ein Spezialfall des allgemeinen interpolativen Modulators mit $H(z) = z^{-1}/(1-z^{-1})$. Der in Figur 3 gezeigte Zwei-Schleifen-Modulator und der zweistufige Modulator in Figur 4 sind nichtinterpolativ; das hier beschriebene Verfahren kann jedoch leicht, z.B. mit Hilfe der in [3] dargestellten Methoden, auf diese Modulatoren angewendet werden. Ebenso können Filter höherer Ordnung, wie z.B. in den Figuren 5a und 5b gezeigt, verwendet werden.

Das erfindungsgemäße Verfahren beruht auf der Vorstellung, daß das gesuchte decodierte Ausgangssignal zwei Bedingungen erfüllen muß:

1. Es muß bandbegrenzt sein.

2. Es muß zur Menge derjenigen Eingangssignale des Modulators gehören, welche durch den Modulator in das zu decodierende Ausgangssignal überführt werden.

Die erste Bedingung wird auch von den bekannten linearen Decodierungsverfahren genutzt, welche im wesentlichen in einer Bandpaßfilterung bestehen. Die zweite Bedingung macht von der konkreten Architektur des Modulators, dessen Ausgangssignal decodiert werden soll, Gebrauch. In [3] wurde ein Verfahren beschrieben, welches grundsätzlich geeignet ist, beide Bedingungen zu berücksichtigen:

Dieses Verfahren basiert auf einer alternierenden Iteration

$$x_{n+1} = P_2(P_1(x_n))$$

mit Hilfe zweier Projektionen $P_1$ und $P_2$ auf zwei konvexe Teilmengen von Signalräumen, wobei die eine Teilmenge diejenigen analogen Eingangssignale des Modulators umfaßt, welche den zu decodierenden binären Datenstrom als Ausgangssignal erzeugen, und wobei die andere Teilmenge gleich dem Raum aller bandbegrenzten Signale ist, der z.B. von einem Satz von bandbegrenzten Basissignalen aufgespannt wird. Die alternierende Iteration konvergiert folglich gegen einen Fixpunkt, welcher der Schnittmenge beider konvexer Teilmengen angehört. Dieses Fixpunktsignal ist folglich die gesuchte digitale Entsprechung desjenigen bandbegrenzten analogen Eingangssignals des Modulators, welches den zu decodierenden binären Datenstrom als Ausgangssignal erzeugt.

Das in [3] beschriebene, nichtlineare Verfahren ist somit dem konventionellen, linearen Ansatz grundsätzlich überlegen, weil es nicht nur die spektralen Eigenschaften des Eingangssignals zur Decodierung verwendet, sondern zusätzlich von der durch die Architektur des Modulators gegebenen Beziehung zwischen dem Eingangssignal und dem Ausgangssignal Gebrauch macht. Leider ist dieses Verfahren mit einem unverhältnismäßig hohen Rechenaufwand verbunden - und deshalb zu teuer und zu langsam -, wodurch seine praktische Verwendbarkeit zur Decodierung von Sigma Delta Modulatoren, die ja gerade durch besonders einfache und daher kostengünstige Schaltungen realisierbar sind, stark eingeschränkt wird.

Bei dem in [3] beschriebenen Verfahren wird die nichtlineare Projektion $P_1$ eines Vektors x ausgeführt, indem ein Vektor x' gesucht wird, dessen euklidischer Abstand

$$\sum_k (x'(k) - x(k))^2$$

zu x minimal ist unter der Nebenbedingung

$(QHx')(k) \leq (QHy)(k)$,

wobei die Matrix $Q = \text{diag}(y_1, \ldots, y_N)$ die Vorzeichen der Ungleichungen bestimmt und die Matrix

$$H = \begin{pmatrix} h_1 & 0 & \cdots & 0 & 0 \\ h_2 & h_1 & \cdots & 0 & 0 \\ \vdots & \vdots & & \vdots & \vdots \\ h_{N-1} & h_{N-2} & \cdots & h_1 & 0 \\ h_N & h_{N-1} & \cdots & h_2 & h_1 \end{pmatrix}$$

durch die Impulsantwortkoeffizienten das in die Modulatorschleife eingebetteten linearen Filters gegeben ist. Hierbei werden - wie in der digitalen Signalverarbeitung üblich - Signale durch Vektoren dargestellt, deren Komponenten zeitliche Abtastwerte darstellen. Der Fachmann sieht sofort, daß die Suche dieses Vektors x' nicht komponentenweise durchgeführt werden kann, obwohl die Ungleichungsnebenbedingungen komponentenweise zu lesen sind, denn die nichtdiagonale Matrix H koppelt die Komponenten des Vektors x untereinander.

In dieser Koppelung liegt die Ursache für den großen Rechenaufwand, der mit dem in [3] beschriebenen Verfahren verbunden ist. Die Erfindung schafft hier Abhilfe, indem für die Vektoren x eine Darstellung gewählt wird, in welcher die Multiplikation mit der Matrix H bereits ausgeführt ist. Die Nebenbedingungen nehmen damit die Form

$(Qx'_H)(K) \leq (QHy)(k)$

an. In dieser Form kann die Minimierung des euklidischen Abstandes

$$\sum_k (x'_H(k) - x_H(k))^2$$

nun leicht komponentenweise ausgeführt werden. Daher bekommt der nichtlineare Projektionsoperator im Falle des interpolativen Modulators die einfache Form

$$P_1(x_n)(k) = \begin{cases} x_n(k) & \texttt{falls}\ \ y(k) \cdot x_n(k) \leq y(k) \cdot (Hy)(k) \\ (Hy)(k) & \texttt{sonst} \end{cases},$$

der man ihre komponentenweise Struktur direkt ansehen kann. In dieser Formel wurde - wie auch im folgenden Text - der Index H am Signalvektor x aus Gründen der Übersichtlichkeit wieder fallengelassen. Man muß jedoch berücksichtigen, daß die Iteration $x_{n+1} = P_2(P_1(x_n))$ nun nicht mehr direkt gegen das gesuchte decodierte Ausgangssignal des Modulators konvergiert, sondern gegen das Bild dieses decodierten Ausgangssignals unter der Matrix H. Deshalb ist der Vektor x am Ende der Iteration z.B. mit der Inversen der Matrix H Zu multiplizieren, um das decodierte Ausgangssignal des Modulators zu erhalten. Dies kann vorteilhaft z.B. durch Filterung mit dem zu H inversen Filter (z.B. Figur 5b) geschehen.

Da alle Vektoren des Iterationsverfahrens nun in einer Darstellung vorliegen, die aus der üblichen Darstellung der Signalvektoren durch eine Multiplikation mit der Matrix H hervorgehen, muß man auch die Projektion $P_2$ auf den Unterraum der bandbegrenzten Eingangssignale in dieser Darstellung ausführen. Verwendete man in der üblichen Darstellung hierzu einen Projektionsoperator, der zu der Form

$$P_2(s) = \sum_i b_i \cdot (b|b)_{i,j}^{-1} \cdot (b_j|s)$$

äquivalent war, so kann man nun einen Projektionsoperator verwenden, der zu der Form

$$P_2(s) = \sum_i Hb_i \cdot (b|H^T Hb)_{i,j}^{-1} \cdot (Hb_j|s)$$

äquivalent ist, also orthogonal auf den Unterraum der mit H multiplizierten Basissignale $b_i = (b_i(1),...,b_i(N))$ des bandbegrenzten Unterraumes projiziert. Hierbei ist ( | ) das euklidische Skalarprodukt

$$(a|b) = a^T b = \sum_k a(k)b(k)$$

auf dem Raum der Signalvektoren und

$$(b|H^T Hb)_{i,j}^{-1}$$

bezeichnen die Koeffizienten der inversen Matrix der Skalarprodukte $(b_q|H^T Hb_r)$. Man rechnet daher leicht nach, daß $P_2 P_2 = P_2$ und

$$P_2^T = P_2$$

gilt, was für einen orthogonalen Projektor notwendig und hinreichend ist.

Die sehr kompakte, explizite Form der Projektionsoperatoren soll nicht bedeuten, daß zu ihrer Anwendung tatsächlich eine Matrixinversion erforderlich wäre. In der Praxis wird man vielmehr ein geeignetes Verfahren zur Orthonormalisierung der transformierten Basissignale, z.B. das übliche Verfahren von Gram-Schmidt, einsetzen. Die Berechnung der transformierten und orthonormalisierten Basissignale ist in jedem Falle kein Vorgang, der die zur Durchführung des erfindungsgemäßen Verfahrens benötigte Rechenzeit erhöhen würde. Da diese Basissignale und die Matrix H allein durch die Architektur des Modulators bestimmt sind und nicht von dem zu decodierenden Ausgangssignal abhängen, können alle notwendigen Berechnungen zur Vorbereitung der Projektion $P_2$ einmalig vor der Durchführung der eigentlichen Decodierung ("offline") durchgeführt werden.

Als Startvektor für die Iteration $x_{n+1} = P_2(P_1(x_n))$ wird vorzugsweise die Wahl $x_0 = y$, also das zu decodierende Ausgangssignal des Modulators selbst, verwendet. In aller Regel verhindert die Wahl des Startvektors bereits das Anwachsen einzelner Signalkomponenten über alle Grenzen. Grundsätzlich ist es aber auch möglich, die Signale bei der Durchführung der nichtlinearen Projektion $P_1$ auf den Hyperwürfel $[-1, +1]^N$ zu beschränken.

Der algorithmisch aufwendigste Teil des hier beschriebenen erfindungsgemäßen Verfahrens ist - im Gegensatz zu dem in [3] beschriebenen Verfahren - die Durchführung der Projektion $P_2$ auf den Unterraum der bandbegrenzten Eingangssignale. Zur Beschleunigung des Verfahrens ist es deshalb in manchen Fällen sinnvoll, auf einen Teil der erreichbaren Genauigkeit zu verzichten, indem einige Komponenten des zu decodierenden Ausgangssignals unberücksichtigt gelassen werden. Dies entspricht einer zeitlichen Unterabtastung des zu decodierenden Ausgangssignals, analog zur Dezimierung bei der linearen Filterung. Wird der Unterabtastfaktor unter Berücksichtigung des Abtasttheorems (Nyquist-Frequenz) geeignet gewählt, führt diese Vorgehensweise lediglich zu sehr geringen bzw. vernachlässigbaren Verlusten bei der Genauigkeit der Decodierung.

Die Unterabtastung des zu decodierenden Ausgangssignals $y = (y(0),...,y(N-1))$ kann formal als Multiplikation mit einer K x N Matrix S beschrieben werden, deren Matrixelemente sämtlich Null sind bis auf eine Eins in jeder Zeile, und die aus dem N-dimensionalen Signalvektor y einen K-dimensionalen Teilvektor Sy mit $(Sy)(k) = y(k)$ auswählt. An die Stelle der Nebenbedingungen der Operation $P_1$ treten nun die neuen Ungleichungen

$$SQx_H = (SQS^T)Sx_H = (SQS^T)x_{SH} \leq SQHy$$

worin $SQS^T$ eine K x K Diagonalmatrix und $Sx_H = x_{SH}$ ein K-dimensionaler Vektor ist. Wegen der Eigenschaften der Matrix S sind diese Nebenbedingungen schwächer - d.h. ihre Zahl ist (u.U. bedeutend!) geringer - als die ursprünglichen, nicht unterabgetasteten Nebenbedingungen. Daher wird zur Durchführung der Operation $P_1$ entsprechend weniger Zeit benötigt. Viel stärker fällt jedoch der Zeitgewinn bei der Ausführung von $P_2$ ins Gewicht, weil hierfür mehr Rechenoperationen pro Komponente von x aus für $P_1$ auszuführen sind! Anstelle von N Summanden, sind in der Summation

$$P_2(s) = \sum_{i=1}^{K} (u_i|s)u_i$$

nun nur K Summanden zu berücksichtigen, wobei die Vektoren $u_i$ eine Orthonormalbasis im Raum der unterabgetasteten, mit H transformierten, bandbegrenzten Eingangssignale sind. Eine solche Basis kann z.B. mit Hilfe des Verfahrens von GramSchmidt aus den Vektoren $SHb_i$ gewonnen werden:

$$Pm,i = (SHb_m|u_i) \text{ für } i = 1,...,m-1$$

$$g_m = SHb_m - \sum_{i=1}^{m-1} p_{m,i}u_i$$

$n_m = (g_m | g_m)$

$u_m = g_m / n_m$

Für die Anwendung der Iterationsformeln ist der Index SH an dem Signalvektor x der Einfachheit halber wieder unterdrückt zu denken; man muß aber im Kopf behalten, daß x mit dem tatsächlichen decodierten Ausgangssignal über eine Multiplikation mit der Matrix SH zusammenhängt, die ganz zum Schluß nach dem Ende der Iteration rückgängig gemacht werden muß.

Die Multiplikation mit S wird z.B. durch eine Entwicklung

$$x_H = \sum_{m=1}^{N} \beta_m \cdot Hb_m$$

nach nicht-unterabgetasteten Basissignalen $Hb_i$ rückgängig gemacht. Die Koeffizienten $\beta_m$ dieser Entwicklung nach den N Basissignalen $b_m$ hängen mit den Koeffizienten der Entwicklung

$$x_{SH} = \sum_{i=1}^{K} (u_i | x_{SH}) \cdot u_i$$

von $x_{SH}$ nach den K Basissignalen $u_i$ über die Beziehungen

$$\beta_m = \frac{1}{n_m} ((u_m | x_{SH}) - \sum_{i=m+1}^{M} (SHb_i | u_m) \cdot \beta_i) \quad \text{für} \quad m = M, ..., 1$$

zusammen. Aus $x_H$ gewinnt man schließlich x - wie im Fall ohne Unterabtastung - durch Multiplikation mit der zu H inversen Matrix. Dabei kann die spezielle Struktur von H vorteilhaft ausgenutzt werden.

Im Zusammenhang mit dem beschriebenen Verfahren kann grundsätzlich jede Auswahlmatrix S zur Unterabtastung verwendet werden. Am einfachsten ist sicherlich eine von den Werten des Ausgangssignals des Modulators unabhängige, gleichförmige Unterabtastung. Sie hat den Vorteil, daß die Matrix S - so wie auch H - bereits vor der Decodierung bekannt ist, weshalb die Orthonormalisierung der Basissignale vor der Decodierung ("offline") ausgeführt werden kann und daher die Rechenzeit des Decodierungsverfahrens nicht erhöht.

Es ist intuitiv einleuchtend, daß die wichtigsten Abtastwerte des zu decodierenden Ausgangssignals y gerade diejenigen sind, bei denen das Eingangssignal u des Quantisierers Q(u) besonders klein ist. Umgekehrt bedeutet dies aber, daß die Abtastwerte mit großen Werten für u nur wenig zur Decodierung beitragen; diese Abtastwerte sind daher am besten dazu geeignet, bei einer - von den Werten des Ausgangssignals abhängigen - Unterabtastung eliminiert zu werden. Dies erfolgt praktisch z.B. mit Hilfe eines weiteren, nicht unbedingt sehr genauen Hilfs-Quantisierers F, welcher den Absolutbetrag des Eingangssignals u des Hauptquantisierers Q einer Schwellwertbildung

$$F(u) = \begin{cases} 1 \text{ falls } |u| < \varepsilon < 1 \\ 0 \text{ sonst} \end{cases}$$

unterwirft. Wählt man zur Unterabtastung dann z.B. die Matrix

8

$$S(k,n) = \begin{cases} 1 \text{ falls } n \text{ der } k\text{-te Zeitindex mit } F(u(k)) = 1 \\ 0 \text{ sonst} \end{cases},$$

so erhält man ein von den laufenden Signalwerten abhängiges Unterabtastschema mit nur minimalem Einfluß auf die Genauigkeit der Decodierung. Ein kleines Beispiel mag dies verdeutlichen:

$$\varepsilon = 0.1$$

$$
\begin{array}{lccccccc}
n & = 1 & 2 & 3 & 4 & 5 & 6 & 7 \\
u & = 0.3 & -0.7 & 0.6 & 0.05 & 0.3 & -0.07 & 0.3 \\
F(u) & = 0 & 0 & 0 & 1 & 0 & 1 & 0
\end{array}
$$

$$S = \begin{pmatrix} 0 & 0 & 0 & 1 & 0 & 0 & 0 \\ 0 & 0 & 0 & 0 & 0 & 1 & 0 \end{pmatrix}$$

Der Preis für diese optimale Wahl einer - nicht regulären - Unterabtastung ist nun aber darin zu sehen, daß die zur Durchführung der Operation $P_2$ benötigte Orthonormalbasis nun für jeden zu decodierenden Ausgangssignalvektor neu und damit während des laufenden Verfahrens immer wieder berechnet werden muß.

Der erfindungsgemäße Algorithmus kann in groben Zügen wie folgt zusammengefaßt werden: Vor der eigentlichen Decodierung wird eine orthonormale Basis von mit der der Matrix H transformierten Basissignalfunktionen des Unterraums der bandgegrenzten Eingangssignale berechnet. Zur eigentlichen Decodierung wird nun das zu decodierende Ausgangssignal y des Modulators mit der Matrix H multipliziert. Daraufhin werden die Iterationsschritte - unter abwechselnder Anwendung der Operatoren $P_1$ und $P_2$ - ausgeführt bis Konvergenz eintritt. Das Ergebnis der Iteration wird mit der zu H inversen Matrix multipliziert. Im Falle einer Unterabtastung wir die Orthonormalisierung mit den unterabgetasteten, bandbegrenzten Basisvektoren durchgeführt. Bei eintretender Konvergenz wird das Ergebnis der Iteration nach den ursprünglichen, nicht unterabgetasteten Basissignalen entwickelt und schließlich mit der zu H inversen Matrix multipliziert.

Der Fachmann ist anhand dieser Beschreibung ohne weiteres in der Lage, das erfindungsgemäße Verfahren mit Hilfe geeigneter elektronischer Schaltungen in Hardware umzusetzen. Dabei können nach seiner Wahl anwendungsspezifische Schaltkreise, programmierbare Schaltungen (Prozessoren) oder beide Schaltungstypen gleichzeitig zum Einsatz kommen. Wegen der großen Vielfalt der dem Fachmann geläufigen, möglichen schaltungstechnischen Realisierungen des erfindungsgemäßen Verfahrens ist ihre auch nur teilweise Darstellung im Rahmen dieser Patentanmeldung allerdings nicht möglich. Deshalb wird auf die einschlägige, dem Fachmann bekannte Literatur verwiesen.

In dieser Patentanmeldung wurden die nachstehenden Veröffentlichungen zitiert:

[1] J.C. Candy et. al. (Eds.), *Oversampling Sigma Delta Converters*. New York: IEEE Press, 1991.

[2] A.V. Oppenheim and R.W. Schafer, *Discrete−Time Signal Processing*, Prentice Hall: Englewood Cliffs, NJ, 1989.

[3] S. Hein und A. Zakhor, *Sigma Delta Modulators*: *Nonlinear Decoding Algorithms and Stability Analysis*, Kluwer Academic Publishers, 1993.

## Patentansprüche

1. Verfahren zur schnellen Decodierung der Ausgangssignale von Sigma Delta Modulatoren, bei dem das decodierte Ausgangssignal eines Modulators mit Hilfe einer Folge $x_{n+1} = P_2(P_1(x_n))$ von Iterationsschritten gewonnen wird, wobei $x_0$ ein vorgegebenes Startsignal ist und

a) in jedem Schritt zwei Operationen $P_1$ bzw. $P_2$ nacheinander ausgeführt werden,

b) Signale s durch Komponenten s(n), s(n-1), s(n-2), ..., s(n-k) dargestellt werden, die zeitliche Abtastwerte dieser Signale sind,

c) die Operation $P_1$ eine Projektion im Raum aller Eingangssignale des Modulators auf die Menge aller derjenigen Eingangssignale ist, welche der Modulator auf das zu decodierende Ausgangssignal abbildet,

d) die Operation $P_2$ eine Projektion auf den Unterraum aller Eingangssignale des Modulators ist, deren Frequenzspektrum in einer vorgegebenen Weise begrenzt ist,

dadurch gekennzeichnet, daß

e) für beide Operationen eine Darstellung der Signale gewählt wird, in welcher die Operation $P_1$ komponentenweise ausgeführt werden kann, so daß jede Komponente $P_1(s)(k)$ von $P_1(s)$ getrennt von allen übrigen Komponenten $P_1(s)(k')$ mit $k' \neq k$ ermittelt wird.

2. Verfahren nach Anspruch 1, bei dem die Operation $P_1$ gemäß der Vorschrift

$$P_1(x_n)(k) = \begin{cases} x_n(k) \quad \texttt{falls} \quad y(k) \cdot x_n(k) \leq y(k) \cdot (Hy)(k) \\ \qquad\qquad (Hy)(k) \quad \texttt{sonst} \end{cases}$$

durchgeführt wird, wobei y der Vektor $y = (y(0),...,y(N-1))$ des zu decodierenden Ausgangssignals des Modulators und

$$H = \begin{pmatrix} h_1 & 0 & \cdots & 0 & 0 \\ h_2 & h_1 & \cdots & 0 & 0 \\ \vdots & \vdots & & \vdots & \vdots \\ h_{N-1} & h_{N-2} & \cdots & h_1 & 0 \\ h_N & h_{N-1} & \cdots & h_2 & h_1 \end{pmatrix}$$

die Matrix der Impulsantwortkoeffizienten des in die nichtlineare Rückkopplungsschleife des Modulators eingebetteten linearen Filters ist.

3. Verfahren nach Anspruch 2, bei dem die Operation $P_2$ zu dem Ausdruck

$$P_2(s) = \sum_i Hb_i \cdot (b|H^T Hb)_{i,j}^{-1} \cdot (Hb_j|s)$$

äquivalent ist, wobei die Vektoren $b_i = (b_i(0),...,b_i(N-1))$ Basissignale eines Unterraumes von bandbegrenzten Signalen im Raum aller Eingangssignale des Modulators, H die Matrix der Impulsantwortkoeffizienten des in die nichtlineare Rückkopplungsschleife des Modulators eingebetteten linearen Filters, ( | ) das euklidische Skalarprodukt auf dem Raum der Signalvektoren und

$$(b|H^T Hb)_{i,j}^{-1}$$

die Koeffizienten der inversen Matrix der Skalarprodukte $(b_q|H^T Hb_r)$ bezeichnen.

4. Verfahren nach einem der vorhergehenden Ansprüche, bei dem eine Iteration der Form $x_{n+1} = P_2(P_1 - (\alpha \cdot x_n + (1-\alpha) \cdot x_{n-1}))$ verwendet wird, wobei der Parameter $\alpha$ bei der Ausführung der Operation $P_1$ optimal gewählt wird.

5. Verfahren nach einem der vorhergehenden Ansprüche, bei dem ein zeitlich unterabgetastetes Ausgangssignal des Modulators decodiert wird.

6. Verfahren nach Anspruch 5, bei dem die Unterabtastung des Ausgangssignals durch den Quantisierungsfehler des Modulators gesteuert wird.

EP 0 666 650 A2

FIG 1

FIG 2

FIG 3

FIG 4

12

# FIG 5

a)

b)